# EUROPÄISCHE PATENTSCHRIFT

(11) **EP 3 670 067 B1**
(45) Veröffentlichungstag und Bekanntmachung des Hinweises auf die Patenterteilung: **27.07.2022**
(21) Anmeldenummer: 18214545.8
(22) Anmeldetag: 20.12.2018
(51) Int. Cl.: B23Q 1/01, G03F 7/20, G03F 9/00, H01L 21/68, G05B 19/19, B23Q 1/48, H01L 21/687

(54) **POSITIONIEREINRICHTUNG IN PORTALBAUWEISE**
POSITIONING DEVICE IN PORTAL DESIGN
DISPOSITIF DE POSITIONNEMENT DE TYPE À PORTIQUE

(43) Veröffentlichungstag der Anmeldung: 24.06.2020
(73) Patentinhaber: ETEL S.A., 2112 Môtiers (CH)
(72) Erfinder: KOBEL, Philipp, 2560 Nidau (CH)
(74) Vertreter: Pleyer, Hans Anno

(56) Entgegenhaltungen:
- EP-A1- 1 810 776
- CN-A- 107 378 514
- DE-A1-102009 008 900
- JP-A- 2012 118 601
- US-A1- 2001 050 341
- US-A1- 2007 216 892

## Beschreibung

### GEBIET DER TECHNIK

Die vorliegende Erfindung betrifft eine Positioniereinrichtung in Portalbauweise. Solche Positioniereinrichtungen dienen beispielsweise in der Halbleiterfertigung zur genauen Positionierung eines beweglichen Elements wie eines Wafertisches in einer Ebene.

### STAND DER TECHNIK

Aus der US 6798088 B2 ist eine Positioniereinrichtung in Portalbauweise bekannt. Zwei parallele Führungen mit Linearantrieben halten einen starren Rahmen mit zwei Querbalken in einer ersten Richtung beweglich. Zwischen diesen Querbalken ist ein bewegliches Element in einer zweiten Richtung beweglich gehalten. Das bewegliche Element kann somit in zwei Richtungen positioniert werden. Da der Rahmen starr ist, kann das bewegliche Element nicht um eine dritte Richtung gedreht werden - eine Anforderung, die es im Bereich der Halbleiterfertigung gibt, um beispielsweise eine leichte Verdrehung eines auf einem Tisch abgelegten Wafers auszugleichen.

Aus der EP 2066996 B1 ist daher eine Positioniereinrichtung in Portalbauweise bekannt, bei der ein einzelner Querbalken so flexibel mit zwei parallelen Linearachsen verbunden ist, dass er durch entsprechende Ansteuerung der Linearachsen um kleine Beträge (wenige Grad) um eine Richtung verdreht werden kann, die senkrecht auf der eigentlichen Bearbeitungsebene der Positioniereinrichtung steht. Das bewegliche Element kann somit in allen drei Freiheitsgraden innerhalb einer Ebene (Translation in zwei Richtungen innerhalb einer Ebene, Rotation um eine dritte Richtung senkrecht zur Ebene, auch in-plane Freiheitsgrade genannt) positioniert werden. Die Schrift offenbart verschiedene Methoden der Positionserfassung des beweglichen Elements, um dieses besonders genau positionieren zu können.

Eine Kombination aus den beiden zuvor genannten Dokumenten offenbart die US 5874820, von dem diese Erfindung ausgeht. Hier ist ein beweglicher Rahmen in einer Positioniereinrichtung offenbart, der wie zuvor zwischen zwei parallelen Linearachsen beweglich gehalten ist. Die Ecken dieses Rahmens sind durch Festkörpergelenke flexibel aneinander gekoppelt, so dass der Rahmen in gewissen Grenzen verdreht werden kann. Ein bewegliches Element ist zwischen den beiden Querbalken des Rahmens geführt. Der Rahmen und das bewegliche Element sind mittels Luftlagern auf einer Basis der Positioniereinrichtung geführt, das bewegliche Element ist außerdem mit seitlichen Luftlagern entlang der beiden Querbalken des Rahmens geführt. Die Herstellung eines solchen Rahmens ist allerdings aufwändig und teuer, da der Rahmen aus sehr hochwertigen Materialien gefertigt und mit mehreren genau bearbeiteten Führungsflächen für die seitlichen Luftlager gefertigt werden muss.

Die EP 1810776 A1 und die CN 107378514 A offenbaren weitere Positioniereinrichtungen, deren Querbalken mit Festkörpergelenk jeweils einen zusätzlichen rotatorischen Freiheitsgrad senkrecht zur Bearbeitungsebene eröffnet. Die US 4098001 offenbart außerdem ein spezielles Festkörpergelenk, das einen virtuellen Drehpunkt aufweist.

### ZUSAMMENFASSUNG DER ERFINDUNG

Es ist Aufgabe der Erfindung, eine Positioniereinrichtung in Portalbauweise anzugeben, mit der eine hochgenaue Positionierung eines beweglichen Elements in drei Freiheitsgraden innerhalb einer Ebene möglich ist, das gegenüber dem Stand der Technik einfacher und kostengünstiger aufgebaut ist.

Diese Aufgabe wird gelöst durch eine Vorrichtung gemäß Anspruch 1. Vorteilhafte Details dieser Vorrichtung ergeben sich auch aus den von Anspruch 1 abhängigen Ansprüchen.

Es wird eine Positioniereinrichtung in Portalbauweise offenbart, mit einer ebenen Basis parallel zu einer ersten Richtung und einer zweiten Richtung, mit zwei in der ersten Richtung angeordneten ersten Linearachsen mit je einem ersten Linearantrieb, wobei die ersten Linearachsen einen Rahmen in der ersten Richtung beweglich halten. Der Rahmen umfasst zwei in der zweiten Richtung verlaufende Querbalken, die an zwei in der ersten Richtung verlaufende Längsbalken befestigt sind und die zusammen mit den Querbalken den Rahmen bilden, wobei je einer der Längsbalken mit je einem der ersten Linearantriebe verbunden ist. Die Querbalken tragen zweite Linearachsen mit je einem zweiten Linearantrieb parallel zur zweiten Richtung, so dass ein bewegliches Element, das zwischen den Querbalken angeordnet ist, mit den zweiten Linearantrieben in der zweiten Richtung beweglich gehalten ist. Der Rahmen ist derart flexibel aufgebaut, dass das bewegliche Element zusätzlich zur Translation in der ersten und zweiten Richtung auch um eine dritte Richtung verdreht werden kann, die senkrecht auf die erste und zweite Richtung steht. Das bewegliche Element ist bezüglich der dritten Richtung und der Rotationen um die erste und zweite Richtung von der ebenen Basis geführt, und bezüglich der ersten Richtung von einer Führungsfläche von genau einem der Querbalken geführt, der damit als Führungsbalken für das bewegliche Element dient.

Gemäß der Erfindung genügt es, nur den einen Führungsbalken des Rahmens aus einem hochwertigen Material und mit einer genau bearbeiteten Fläche herzustellen, während die drei weiteren Balken des Rahmens aus einem kostengünstigen Material wie etwa Aluminium gefertigt sein können. Dadurch kann der Rahmen einerseits leichter ausgeführt werden, was Vorteile bei der Dynamik der Positioniereinrichtung bringt. Andererseits sind die Materialkosten, sowie durch eine vereinfachte Bearbeitung der weniger hochwertigen Materialien auch die Bearbeitungskosten und damit insgesamt die Herstellungskosten für so einen Rahmen niedriger als im Stand der Technik.

Verbindet man in den Ecken des Rahmens die Längs- und Querbalken auf geeignete Weise miteinander, so ermöglicht man in gewissen Grenzen die Positionierung des beweglichen Elements auch bezüglich einer Rotation um die dritte, zur ebenen Basis senkrechten Richtung. Hierfür ist es vorteilhaft, wenn Gelenke in den Ecken des Rahmens insgesamt vier Freiheitsgrade freigeben, die in der Ebene der Basis liegen. Diese hier auch in-plane Freiheitsgrade genannten Freiheitsgrade sind Translationen in die erste und zweite Richtung, parallel zur Ebene der Basis, und Rotationen um die dritte Richtung, senkrecht zur Basis. Im einfachsten Fall lässt sich dies durch je ein Festkörpergelenk in jeder der vier Ecken des Rahmens erreichen, wobei die Festkörpergelenke jeweils die Rotation um die dritte Richtung freigeben. Der Rahmen kann dann also in den Ecken Winkel aufweisen, die von 90 Grad verschieden sind. Die Querbalken stehen dann nicht mehr senkrecht auf den Längsbalken, sind aber untereinander weiterhin parallel.

In einer bevorzugten Ausführungsform weist die Positioniereinrichtung zwischen einem vorgespannten Luftlager, mit dem das bewegliche Element am Führungsbalken geführt ist, und dem beweglichen Element selbst ein Gelenk mit einem virtuellen Drehpunkt auf, der im Schwerpunkt des beweglichen Elements liegt. Auf diese Weise entsteht bei der Beschleunigung des beweglichen Elements in der zweiten Richtung kein Drehmoment um die dritte Richtung.

Weitere Vorteile und Einzelheiten der vorliegenden Erfindung ergeben sich aus der nachfolgenden Beschreibung verschiedener Ausführungsformen anhand der Figuren.

### KURZE BESCHREIBUNG DER ZEICHNUNGEN

Dabei zeigt
- Figur 1: eine 3D-Darstellung der Positioniereinrichtung,
- Figur 2: eine Draufsicht des Rahmens der Positioniereinrichtung,
- Figur 3: eine Draufsicht eines Rahmens gemäß einem weiteren Ausführungsbeispiel,
- Figur 4: ein Gelenk mit einem virtuellen Drehpunkt,
- Figur 5: die Positionierung des Gelenks der Figur 4 zwischen einem Luftlager und dem beweglichen Element.

### BESCHREIBUNG DER AUSFÜHRUNGSFORMEN

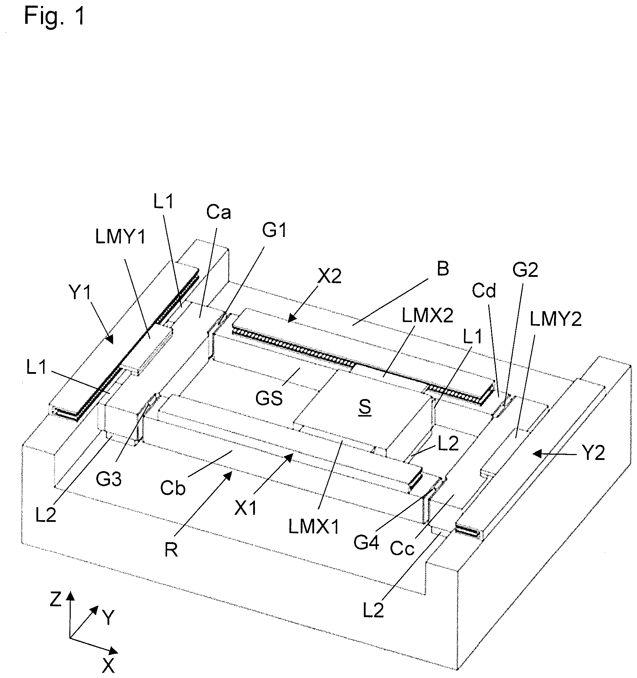

Die Figur 1 zeigt eine 3D-Ansicht der Positioniereinrichtung gemäß einem ersten Ausführungsbeispiel. Eine ebene Basis B trägt zwei parallele Linearachsen Y1, Y2 mit ersten Linearantrieben LMY1, LMY2 parallel zu einer ersten Richtung Y, die in der Ebene der Basis B liegt. Als Linearachse sei hier eine Kombination aus Linearführung, Linearmotor und Positionsmesseinrichtung verstanden, wie sie in Positioniereinrichtungen üblich sind. Mit einer entsprechenden Ansteuerung können solche Achsen in bekannter Weise positioniert werden.

Die beweglichen Läufer der Linearantriebe LMY1, LMY2 sind mit je einem Längsbalken Ca, Cc eines Rahmens R verbunden. Die Längsbalken Ca, Cc liegen parallel zur ersten Richtung Y. Der Rahmen R ist insgesamt in der ersten Richtung Y beweglich geführt und durch die ersten Linearantriebe LMY1, LMY2 positionierbar.

Der Rahmen R weist außerdem zwei Querbalken Cb, Cd auf, die im Wesentlichen in einer zur ersten Richtung Y senkrechten zweiten Richtung X verlaufen. In den Ecken des Rahmens R sind die Längs- und Querbalken Ca, Cc, Cb, Cd in diesem ersten Ausführungsbeispiel mit vier Gelenken G1, G2, G3, G4 verbunden, die als Festkörpergelenke ausgeführt sind und die jeweils einen rotatorischen Freiheitsgrad um eine dritte Richtung Z freigeben, der senkrecht auf der ebenen Basis B steht, während alle anderen Freiheitsgrade durch die Gelenke G1, G2, G3, G4 gesperrt sind. Der Rahmen R kann dadurch in gewissen Grenzen so verformt werden, dass die Querbalken Cb, Cd etwas von der zweiten Richtung X abweichen. Die Gelenke G1, G2, G3, G4 geben in diesem Ausführungsbeispiel also insgesamt vier in-plane Freiheitsgrade frei.

Die Querbalken Cb, Cd weisen außerdem je eine zweite Linearachse X1, X2 auf, die über zweite Linearantriebe LMX1, LMX2 verfügen. Die beweglichen Läufer dieser zweiten Linearantriebe LMX1, LMX2 sind mit einem beweglichen Element S verbunden, dessen Positionierung die eigentliche Aufgabe der Positioniereinrichtung ist. Das bewegliche Element S kann beispielsweise einen Tisch zur Ablage eines Wafers tragen, der dann mit der Positioniereinrichtung unter einem Mikroskop positionierbar ist. Dadurch kann der Wafer an verschiedenen Stellen inspiziert werden. Zur Korrektur von einer beim Ablegen des Wafers kaum vermeidbaren leichten Verdrehung des Wafers kann dank der Gelenke G1, G2, G3, G4 eine entsprechende gegenläufige Drehung des beweglichen Elements S bewirkt werden, indem die zweiten Linearantriebe LMX1, LMX2 gegenläufig angesteuert werden. Dann liegen die Strukturen des Wafers wie üblicherweise gewünscht exakt parallel zur ersten und zweiten Richtung Y, X ausgerichtet unter dem Mikroskop.

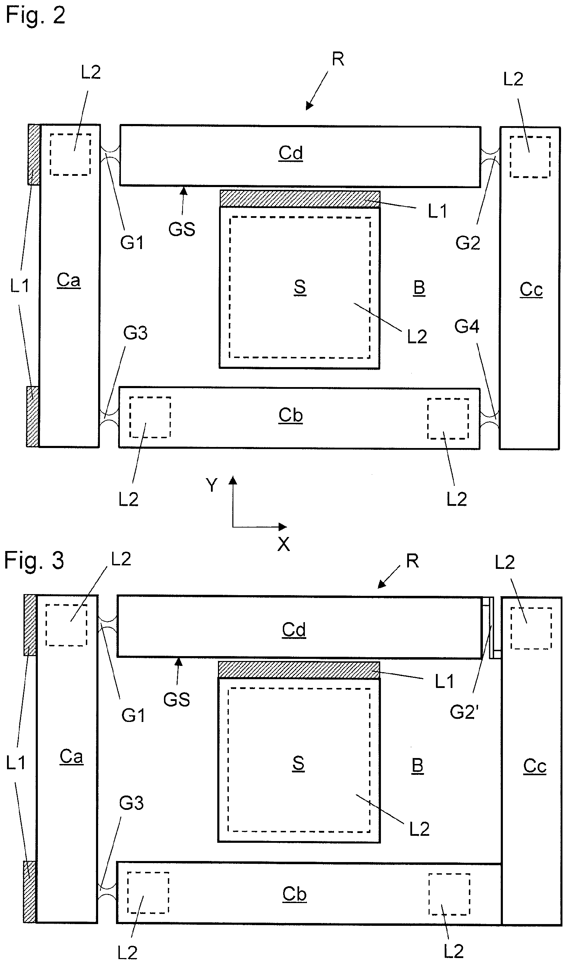

Um die Reibung möglichst gering zu halten, sind die beweglichen Teile der Positioniereinrichtung mit Luftlagern L1, L2 ausgestattet, deren Anordnung in der Figur 2 besser zu erkennen ist. In dieser Figur 2 wie auch in der folgenden Figur 3 sind die Linearantriebe LMY1, LMY2, LMX1, LMX2 der besseren Übersichtlichkeit halber nicht dargestellt, hier sei auf die Figur 1 verwiesen.

Der Längsbalken Ca und damit der ganze Rahmen R ist mittels zweier seitlicher Luftlager L1 an einem vertikalen und in der ersten Richtung Y verlaufenden Vorsprung der Basis B geführt. Es werden hier vorgespannte Luftlager eingesetzt, so dass der gegenüberliegende Querbalken Cc des Rahmens R nicht separat mit seitlichen Luftlagern geführt werden muss. Solche gegenüberliegende seitliche Luftlager am Querbalken Cc wären aber eine denkbare Abwandlung der gezeigten Ausführungsform. Die einander gegenüberliegenden Luftlager würden sich dann gegenseitig vorspannen.

Gegenüber der ebenen Basis B wird der Rahmen R mit vier horizontalen Luftlagern L2 abgestützt, deren Anordnung in der Figur 2 gut zu erkennen ist, und deren bevorzugte Anordnung weiter unten noch genauer erklärt wird. Hier kann es sich um herkömmliche Luftlager handeln, die vom Gewicht des Rahmens R vorgespannt werden. Da dessen Masse aber relativ gering ist, sind auch hier mittels Vakuum vorgespannte Luftlager bevorzugt, um eine ausreichend große Steifigkeit der horizontalen Luftlager L2 zu erreichen. Gleiches gilt auch für das horizontale Luftlager L2 des beweglichen Elements S.

Mit einem vorgespannten seitlichen Luftlager L1 wird außerdem das bewegliche Element S an einer ins Innere des Rahmens R weisenden Führungsfläche GS des Querbalkens Cd geführt. Dieser Querbalken Cd wird daher auch als Führungsbalken Cd bezeichnet. Dieses seitliche Luftlager L1 zwischen dem beweglichen Element S und dem Führungsbalken Cd bzw. der Führungsfläche GS sorgt dafür, dass das bewegliche Element S allen Bewegungen des Rahmens R in die erste Richtung Y folgt. Anders gesagt wird das bewegliche Element S bezüglich der ersten Richtung Y von der Führungsfläche GS des Führungsbalkens Cd geführt.

Besonders vorteilhaft ist es, dass im Rahmen R nur der Führungsbalken Cd aus einem besonders hochwertigen Material (beispielsweise mit einem niedrigen thermischen Ausdehnungskoeffizient oder besonders hoher Festigkeit) gefertigt und bezüglich seiner Führungsfläche GS besonders genau bearbeitet werden muss. Die anderen Balken Ca, Cb, Cc des Rahmens R können dagegen aus weniger hochwertigen Materialien bestehen, und müssen weniger genau bearbeitet werden. Als Material für den Führungsbalken Cd bietet sich beispielsweise Siliziumkarbid SiC oder aus Aluminiumoxid Al₂O₃ an, während die übrigen Balken aus Aluminium gefertigt sein können. Für alle Balken Ca, Cb, Cc, Cd des Rahmens R gilt, dass sie bevorzugt als Hohlprofile ausgebildet sind.

Die Figur 3 zeigt ein weiteres Ausführungsbeispiel der Erfindung, bei der die Ausgestaltung der Ecken des Rahmens R verändert ist. Die in der Figur 3 rechts unten liegende Ecke ist nun als starre Verbindung ohne Gelenk ausgebildet. Um dennoch vier in-plane Freiheitsgrade zu erhalten, ist deshalb das rechts oben eingezeichnete Gelenk G2' ein Festkörpergelenk, das neben dem rotatorischen Freiheitsgrad um die dritte Richtung Z einen translatorischen Freiheitsgrad in die zweite Richtung X freigibt, während alle anderen Freiheitsgrade gesperrt sind. Zusammen mit den beiden rotatorischen Freiheitsgraden der Festkörpergelenke G1 und G3 sind also wieder vier in-plane Freiheitsgrade im Rahmen R vorhanden. Auch dieser Rahmen kann sich in gewissen Grenzen so verformen, dass das bewegliche Element S um die dritte Richtung Z gedreht werden kann. Andere Kombinationen von Gelenken sind möglich, wenn sie ebenfalls insgesamt vier in-plane Freiheitsgrade freigeben.

Zur Anordnung der horizontalen Luftlager L2, wie sie in den Figuren 2 und 3 gut zu erkennen ist, sei noch Folgendes erklärt: Der Rahmen R wird durch die horizontalen Luftlager L2 gegen die Schwerkraft abgestützt. Die zwischen den horizontalen Luftlagern L2 liegenden Balken Ca, Cb, Cc, Cd stellen schwingungsfähige Komponenten dar. Es sollte bei der Platzierung der horizontalen Luftlager L2 darauf geachtet werden, dass die Resonanzfrequenzen der Balken zwischen den Luftlagern in etwa gleich sind. Für den Rahmen R gemäß der Erfindung hat dies die Folge, dass der Rahmen R mittels vier horizontalen Luftlagern L2 auf der ebenen Basis B geführt ist, von denen zwei horizontale Luftlager L2 unter den Längsbalken Ca, Cc, und zwar an deren dem Führungsbalken Cd nahe gelegenen Enden liegen, und weitere zwei horizontale Luftlager L2 unter dem zum Führungsbalken Cd parallel liegenden Querbalken Cb liegen, und zwar jeweils an den beiden Enden dieses Querbalkens Cb. Damit sind die Abstände zwischen den horizontalen Luftlagern L2, die mit den Querbalken Ca, Cb, Cc überbrückt sind, in etwa gleich groß, während der Abstand der horizontalen Luftlager L2, der vom Führungsbalken Cd überbrückt ist, etwas größer ist. Dank besseren Materialeigenschaften weist der Führungsbalken Cd trotz längerer Spannweite ungefähr gleich hohe Resonanzfrequenzen auf wie die kürzeren Abschnitte zwischen den horizontalen Luftlager L2 aus Aluminium.

Alternativ und nicht in einer Figur dargestellt kann auch vorgesehen sein, dass z.B. in größeren Maschinen der Rahmen R mittels fünf horizontalen Luftlagern L2 auf der ebenen Basis B geführt ist, von denen je zwei horizontale Luftlager L2 unter den Längsbalken Ca, Cc, und zwar an deren den Querbalken Cb, Cd nahe gelegenen Enden liegen, und wobei ein weiteres horizontales Luftlager L2 unter dem zum Führungsbalken Cd parallel liegenden Querbalken Cb liegt, und zwar in der Mitte dieses Querbalkens Cb. Auch diese Anordnung führt zu in etwa gleichen Abständen der vom Aluminium überbrückten Bereiche zwischen den horizontalen Luftlagern L2, und zu einem größeren Abstand entlang des aus dem hochwertigen Material gefertigten Führungsbalken Cd. Für kleinere Maschinen können auch nur drei horizontale Luftlager unter dem Rahmen R ausreichen. Hierfür können die beiden in der Figur 2 an den Enden des Balkens Cb angeordneten Luftlager L2 durch ein einziges in der Mitte des Balkens Cb ersetzt werden.

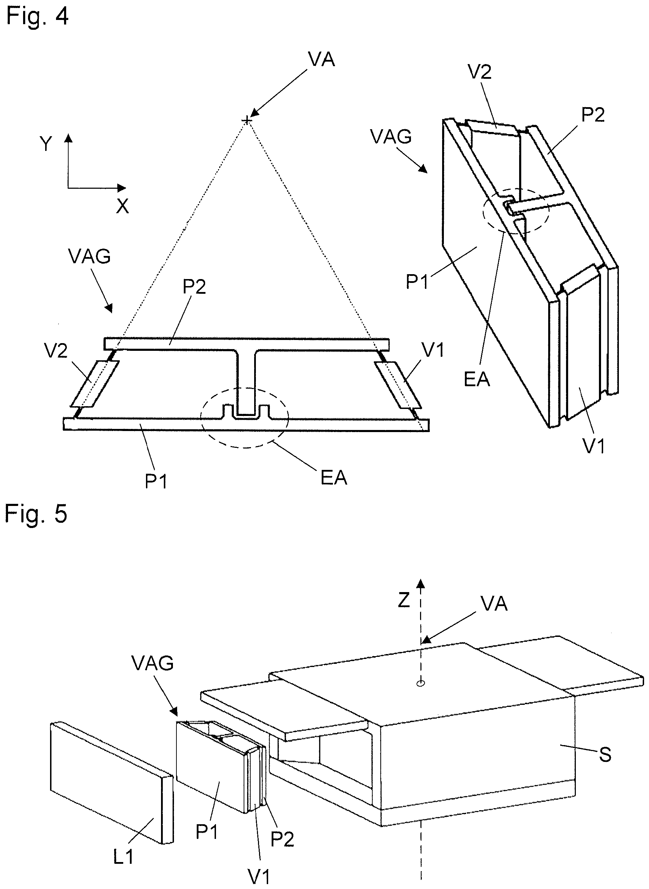

Die Tatsache, dass das bewegliche Element S nur auf der dem Führungsbalken Cd zugewandten Seite an dessen Führungsfläche GS bezüglich der ersten Richtung Y geführt wird, führt zu einer gewissen Asymmetrie der Anordnung. Im Falle einer Beschleunigung des beweglichen Elements S in die zweite Richtung X können durch das schwere, nur auf einer Seite des beweglichen Elements S angeordnete seitliche Luftlager L1 unerwünschte Drehmomente entstehen. Um dies zu vermeiden, wird ein in der Figur 4 dargestelltes Gelenk VAG mit virtueller Drehachse VA verwendet, das wie in der Figur 5 gezeigt zwischen das an der Führungsfläche GS gleitende seitliche Luftlager L1 und das bewegliche Element S eingesetzt wird. Die virtuelle Drehachse VA verläuft dabei durch den Massenschwerpunkt des beweglichen Elements S und senkrecht zur ebenen Basis B. Bei der Beschleunigung des beweglichen Elements S mit seitlichem Luftlager L1 in die zweiten Richtung X erzeugt das seitliche Luftlager L1 ein Drehmoment und eine Kraft proportional zur Beschleunigung. Das Drehmoment wird auf den Führungsbalken Cd übertragen, die Kraft wirkt an der virtuellen Drehachse VA auf das bewegliche Element S. Da der Massenschwerpunkt des beweglichen Elementes S und die virtuelle Drehachse VA genau in der Mitte der zweiten Linearantriebe LMX1, LMX2 liegen, können die zweiten Linearantriebe LMX1, LMX2 perfekt ausgeglichen mit derselben Kraft beschleunigen.

Dasselbe gilt auch für Drehbeschleunigung um die zentrale Rotationachse, wobei die Motoren mit der gleichen gegensätzlichen Kraft beschleunigen können und was zu einer optimalen Auslastung führt.

Das Gelenk VAG mit virtueller Drehachse VA ist aus zwei parallelen Platten P1, P2 aufgebaut, die von zwei gegeneinander geneigten Verbindungsstegen V1, V2 auf Abstand gehalten werden. Die Verbindungsstege V1, V2 weisen Schwachstellen auf und wirken als Festkörpergelenke, so dass sich die eine Platte P2 gegen die andere Platte P1 neigen kann. Die virtuelle Drehachse VA dieser Neigungsbewegung liegt dabei außerhalb des Gelenks VAG.

Das Gelenk VAG mit virtueller Drehachse VA weist zudem einen mechanischen Endanschlag EA auf, der eine zu große Auslenkung und damit Beschädigung des Gelenks VAG verhindern soll. Im Beispiel ist das durch einen Vorsprung an der einen Platte P2 gelöst, der in eine gegenüberliegende Aufnahme oder Vertiefung an der anderen Platte P1 ragt, ohne diese zu berühren. Bei maximaler Auslenkung berührt der Vorsprung an der Platte P2 die gegenüberliegende Vertiefung in der Platte P1. Der Spielraum zwischen Vorsprung und Vertiefung bestimmt die maximale mögliche Auslenkung des Gelenkes VAG.

Durch das Gelenk VAG mit virtueller Drehachse VA ist die Rotation des beweglichen Elements S um die dritte Richtung Z vom Führungsbalken Cd entkoppelt. Diese Rotation wird daher ausschließlich durch die beiden zweiten Linearantriebe LMX1, LMX2 eingestellt.

Bevorzugt wird der jeweilige Aufbau auf dem beweglichen Element S (also beispielsweise ein Tisch oder Chuck zur Ablage eines Wafers) so angebaut, dass dessen Zentrum mit dem Zentrum des beweglichen Elements S übereinstimmt. Diese gemeinsame Drehachse entspricht dann dem kleinsten Trägheitsmoment und ermöglicht somit die höchste Dynamik. Zudem werden durch die zentrale virtuelle Rotationsachse keine zusätzlichen Korrekturen in X und Y benötigt, so dass der Rahmen R hierfür nicht beschleunigt werden muss. Dies ermöglicht eine energieeffiziente Ansteuerung des beweglichen Elements S.

## Patentansprüche

1. Positioniereinrichtung in Portalbauweise, mit einer ebenen Basis (B) parallel zu einer ersten Richtung (Y) und einer zweiten Richtung (X), mit zwei in der ersten Richtung (Y) angeordneten ersten Linearachsen (Y1, Y2) mit je einem ersten Linearantrieb (LMY1, LMY2), wobei die ersten Linearachsen (Y1, Y2) einen Rahmen (R) in der ersten Richtung (Y) beweglich halten, wobei der Rahmen (R) zwei in der zweiten Richtung (X) verlaufende Querbalken (Cb, Cd) umfasst, die an zwei in der ersten Richtung (Y) verlaufende Längsbalken (Ca, Cc) befestigt sind und die zusammen mit den Querbalken (Cb, Cd) den Rahmen (R) bilden, wobei je einer der Längsbalken (Ca, Cc) mit je einem der ersten Linearantriebe (LMY1, LMY2) verbunden ist, und wobei die Querbalken (Cb, Cd) zweite Linearachsen (X1, X2) mit je einem zweiten Linearantrieb (LMX1, LMX2) parallel zur zweiten Richtung (X) tragen, so dass ein bewegliches Element (S), das zwischen den Querbalken (Cb, Cd) angeordnet ist, mit den zweiten Linearantrieben (LMX1, LMX2) in der zweiten Richtung (X) beweglich gehalten ist, wobei der Rahmen (R) derart flexibel aufgebaut ist, dass das bewegliche Element (S) zusätzlich zur Translation in der ersten und zweiten Richtung (Y, X) auch um eine dritte Richtung (Z) verdreht werden kann, die senkrecht auf der ersten und zweiten Richtung (Y, X) steht, wobei das bewegliche Element (S) bezüglich der dritten Richtung (Z) und der Rotationen um die erste und zweite Richtung (Y, X) von der ebenen Basis (B) geführt ist, wobei das bewegliche Element (S) bezüglich der ersten Richtung (Y) von einer Führungsfläche (GS) von genau einem der Querbalken (Cb, Cd) geführt ist, der damit als Führungsbalken (Cd) für das bewegliche Element (S) dient.

2. Positioniereinrichtung nach Anspruch 1, wobei der Führungsbalken (Cd) über Gelenke (G1, G2, G2') mit den Längsbalken (Ca, Cc) verbunden ist, die jeweils eine Rotation um die dritte Richtung (Z) ermöglichen.

3. Positioniereinrichtung nach Anspruch 2, wobei eines der Gelenke (G2') am Führungsbalken (Cb) zusätzlich eine Translation in der ersten Richtung (X) ermöglicht.

4. Positioniereinrichtung nach Anspruch 3, wobei in einer Ecke des Rahmens (R) ein Querbalken (Cb) und ein Längsbalken (Cc) starr miteinander verbunden sind.

5. Positioniereinrichtung nach einem der Ansprüche 2 - 4, wobei die Gelenke (G1, G2, G2', G3, G4) zwischen den Längsbalken (Ca, CC) und Querbalken (Cb, Cd) des Rahmes (R) die Querbalken (Cb, Cd) und Längsbalken (Ca, Cc) so miteinander verbinden, dass insgesamt vier in-plane Freiheitsgrade dem Rahmen (R) Flexibilität verleihen.

6. Positioniereinrichtung nach einem der Ansprüche 2 - 5, wobei die Gelenke (G1, G2, G2', G3, G4) Festkörpergelenke sind.

7. Positioniereinrichtung nach einem der vorhergehenden Ansprüche, wobei der Führungsbaiken (Cd) aus einem Material gefertigt ist, das sich vom Material der Längsbalken (Ca, Cc) und des zweiten Querbalkens (Cb) unterscheidet

8. Positioniereinrichtung nach Anspruch 7, wobei der Führungsbalken (Cd) aus Siliziumkarbid oder aus Aluminiumoxid gefertigt ist.

9. Positioniereinrichtung nach Anspruch 7 oder 8, wobei die Längsbalken (Ca, Cc) und der zweite Querbalken (Cb) aus Aluminium gefertigt sind.

10. Positioniereinrichtung nach einem der Ansprüche 7 - 9, wobei der Führungsbalken (Cd) ein Hohlprofil aufweist.

11. Positioniereinrichtung nach einem der Ansprüche 7 - 10, wobei der Rahmen (R) mittels vier horizontalen Luftlagern (L2) auf der ebenen Basis (B) geführt ist, von denen zwei horizontale Luftlager (L2) unter den Längsbalken (Ca, Cc), und zwar an deren dem Führungsbalken (Cd) nahe gelegenen Enden liegen, und weitere zwei horizontale Luftlager (L2) unter dem zum Führungsbalken (Cd) parallelliegenden Querbalken (Cb) liegen, und zwar jeweils an den beiden Enden dieses Querbalkens (Cb).

12. Positioniereinrichtung nach einem der Ansprüche 7 - 10, wobei der Rahmen (R) mittels fünf horizontalen Luftlagern (L2) auf der ebenen Basis (B) geführt ist, von denen je zwei horizontale Luftlager (L2) unter den Längsbalken (Ca, Cc), und zwar an deren den Querbalken (Cb, Cd) nahe gelegenen Enden liegen, und wobei ein weiteres horizontales Luftlager (L2) unter dem zum Führungsbalken (Cd) parallel liegenden Querbalken (Cb) liegt, und zwar in der Mitte dieses Querbalkens (Cb).

13. Positioniereinrichtung nach einem der vorhergehenden Ansprüche, wobei das bewegliche Element (S) mittels eines vorgespannten seitlichen Luftlagers (L1) an der Führungsfläche (GS) des Führungsbalkens (Cd) geführt ist.

14. Positioniereinrichtung nach einem der vorhergehenden Ansprüche, wobei zwischen der Führungsfläche (GS) des Führungsbalkens (Cd) und dem beweglichen Element (S) ein Gelenk (VAG) angeordnet ist, das eine virtuelle Drehachse (VA) für eine Rotation des beweglichen Elements (S) um die dritte Richtung (Z) aufweist.

15. Positioniereinrichtung nach Anspruch 14, wobei die virtuelle Drehachse (VA) durch einen Massenschwerpunkt des beweglichen Elements (S) verläuft.

16. Positioniereinrichtung nach Anspruch 14 oder 15, wobei die Rotation des beweglichen Elements (S) um eine dritte Richtung (Z), die senkrecht auf die erste und zweite Richtung (Y, X) steht, mittels der zweiten Linearantriebe (LMX1, LMX2) einstellbar ist.

## Claims

1. Positioning device in portal design, with a level base (B) parallel to a first direction (Y) and a second direction (X), with two first linear axes (Y1, Y2) arranged in the first direction (Y) and in each case with a first linear drive (LMY1, LMY2), wherein the first linear axes (Y1, Y2) hold a frame (R) in movable manner in the first direction (Y), wherein the frame (R) comprises two cross beams (Cb, Cd) which run in the second direction (X) and which are attached to two longitudinal beams (Ca, Cc) running in the first direction (Y) and which together with the cross beams (Cb, Cd) form the frame (R) wherein each one of the longitudinal beams (Ca, Cc) is connected to one each of the first linear drives (LMY1, LMY2), and wherein the cross beams (Cb, Cd) support second linear axes (X1, X2) each with a second linear drive (LMX1, LMX2) parallel to the second direction (X), so that a movable element (S) which is disposed between the cross beams (Cb, Cd), is held with the second linear drives (LMX1, LMX2) in movable manner in the second direction (X), wherein the frame (R) is of flexible structure such that the movable element (S) in addition to translation in the first and second direction (Y, X) can also be turned about a third direction (Z), which is perpendicular to the first and second direction (Y, X), wherein the movable element (S) is guided relative to the third direction (Z) and the rotations about the first and second direction (Y, X) from the level base (B), wherein the movable element (S) is guided relative to the first direction (Y) from a guide surface (GS) from just one of the cross beams (Cb, Cd) which thus serves as the guide beam (Cd) for the movable element (S).

2. Positioning device according to Claim 1, wherein the guide beam (Cd) is connected via articulated joints (G1, G2, G2') to the longitudinal beams (Ca, Cc) which each enable rotation about the third direction (Z).

3. Positioning device according to Claim 2, wherein one of the articulated joints (G2') on the guide beam (Cb) enables in addition a translation in the first direction (X).

4. Positioning device according to Claim 3, wherein a cross beam (Cb) and a longitudinal beam (Cc) are rigidly connected to one another in one corner of the frame (R).

5. Positioning device according to one of Claims 2 - 4, wherein the articulated joints (G1, G2, G2', G3, G4) between the longitudinal beams (Ca, Cc) and the cross beams (Cb, Cd) of the frame (R) connect the cross beams (Cb, Cd) and longitudinal beams (Ca, Cc) to one another in such a way that the frame (R) is provided in total with flexibility in four in-plane degrees of freedom.

6. Positioning device according to one of Claims 2 to 5, wherein the flexible joints (G1, G2, G2', G3, G4) are flexure joints.

7. Positioning device according to one of the preceding Claims, wherein the guide beams (Cd) are made from a material which differs from the material of the longitudinal beams (Ca, Cc) and the second cross beam (Cb).

8. Positioning device according to Claim 7, wherein the guide beam (Cd) is made from silicon carbide or from aluminium oxide.

9. Positioning device according to Claim 7 or 8, wherein the longitudinal beams (Ca, Cc) and the second cross beam (Cb) are made from aluminium.

10. Positioning device according to one of Claims 7 to 9, wherein the guide beam (Cd) has a hollow profile.

11. Positioning device according to one of Claims 7 to 10, wherein the frame (R) is guided on the level base (B) by means of four horizontal air bearings (L2) of which two horizontal air bearings (L2) lie beneath the longitudinal beams (Ca, Cc), namely at their ends close to the guide beam longitudinal (Cd), and two further horizontal air bearings (L2) lie beneath the cross beam lying parallel to the guide beam (Cd), namely one each at the two ends of this cross beam (Cb).

12. Positioning device according to one of Claims 7 to 10, wherein the frame (R) is guided by means of five horizontal air bearings (L2) on the level base (B), of which each two horizontal air bearings (L2) lie beneath the longitudinal beams (Ca, Cc), namely at their ends close to the cross beams (Cb, Cd), and wherein a further horizontal air bearing (L2) lies beneath the cross beam (Cb) lying parallel to the guide beam (Cd), namely in the middle of this cross beam (Cb).

13. Positioning device according to one of the preceding Claims, wherein the movable element (S) is guided on the guide surface (GS) of the guide beam (Cd) by means of a pretensioned lateral air bearing (L1).

14. Positioning device according to one of the preceding Claims, wherein an articulated joint (VAG) is disposed between the guide surface (GS) of the guide beam (Cd) and the movable element (S), and this joint has a virtual axis of rotation (VA) for rotation of the movable element (S) about a third direction (Z).

15. Positioning device according to Claim 14, wherein the virtual axis of rotation (VA) runs through a centre of gravity of the movable element (S).

16. Positioning device according to Claim 14 or 15, wherein the rotation of the movable element (S) can be adjusted by means of the second linear drives (LMX1, LMX2) about a third direction (Z) which lies perpendicular to the first and second direction (Y, X)

## Revendications

1. Dispositif de positionnement à structure en portique, comportant une base plane (B) parallèle à une première direction (Y) et à une deuxième direction (X), comportant deux premiers axes linéaires (Y1, Y2) disposés dans la première direction (Y) et dotés respectivement d'un premier entraînement linéaire (LMY1, LMY2), les premiers axes linéaires (Y1, Y2) retenant un cadre (R) de manière mobile dans la première direction (Y), le cadre (R) comportant deux poutres transversales (Cb, Cd) s'étendant dans la deuxième direction (X), lesquelles sont fixées à deux poutres longitudinales (Ca, Cc) s'étendant dans la première direction (Y) et forment le cadre (R) conjointement avec les poutres transversales (Cb, Cd), l'une des poutres longitudinales (Ca, Cc) étant reliée respectivement à l'un des premiers entraînements linéaires (LMY1, LMY2) respectivement, et les poutres transversales (Cb, Cd) portant des deuxièmes axes linéaires (X1, X2) comportant respectivement un deuxième entraînement linéaire (LMX1, LMX2) parallèle à la deuxième direction (X), de sorte qu'un élément mobile (S), qui est disposé entre les poutres transversales (Cb, Cd), soit retenu de manière mobile dans la deuxième direction (X) à l'aide des deuxièmes entraînements linéaires (LMX1, LMX2), le cadre (R) étant construit de manière flexible de telle sorte que l'élément mobile (S) puisse, en plus de la translation dans la première et la deuxième direction (Y, X), également être entraîné en rotation autour d'une troisième direction (Z) qui est perpendiculaire à la première et à la deuxième direction (Y, X), l'élément mobile (S) étant guidé par la base plane (B) par rapport à la troisième direction (Z) et aux rotations autour de la première et de la deuxième direction (Y, X), l'élément mobile (S) étant guidé par une surface de guidage (GS) d'exactement l'une des poutres transversales (Cb, Cd) par rapport à la première direction (Y), laquelle poutre transversale sert par conséquent de poutre de guidage (Cd) pour l'élément mobile (S).

2. Dispositif de positionnement selon la revendication 1, la poutre de guidage (Cd) étant reliée aux poutres longitudinales (Ca, Cc) par le biais d'articulations (G1, G2, G2') qui permettent respectivement une rotation autour de la troisième direction (Z).

3. Dispositif de positionnement selon la revendication 2, l'une des articulations (G2') sur la poutre de guidage (Cb) permettant en outre une translation dans la première direction (X).

4. Dispositif de positionnement selon la revendication 3, une poutre transversale (Cb) et une poutre longitudinale (Cc) étant reliées rigidement l'une à l'autre dans un coin du cadre (R).

5. Dispositif de positionnement selon l'une des revendications 2 à 4, les articulations (G1, G2, G2', G3, G4) entre les poutres longitudinales (Ca, CC) et les poutres transversales (Cb, Cd) du cadre (R) reliant les unes aux autres les poutres transversales (Cb, Cd) et les poutres longitudinales (Ca, Cc) de telle sorte qu'en tout quatre degrés de liberté dans le plan confèrent une flexibilité au cadre (R).

6. Dispositif de positionnement selon l'une des revendications 2 à 5, les articulations (G1, G2, G2', G3, G4) étant des articulations monolithiques.

7. Dispositif de positionnement selon l'une des revendications précédentes, la poutre de guidage (Cd) étant fabriquée à partir d'un matériau qui diffère du matériau des poutres longitudinales (Ca, Cc) et de la deuxième poutre transversale (Cb).

8. Dispositif de positionnement selon la revendication 7, la poutre de guidage (Cd) étant fabriquée à partir de carbure de silicium ou à partir d'oxyde d'aluminium.

9. Dispositif de positionnement selon la revendication 7 ou 8, les poutres longitudinales (Ca, Cc) et la deuxième poutre transversale (Cb) étant fabriquées à partir d'aluminium.

10. Dispositif de positionnement selon l'une des revendications 7 à 9, la poutre de guidage (Cd) présentant un profil creux.

11. Dispositif de positionnement selon l'une des revendications 7 à 10, le cadre (R) étant guidé sur la base plane (B) au moyen de quatre paliers d'air (L2) horizontaux, parmi lesquels deux paliers d'air (L2) horizontaux se situent en dessous des poutres longitudinales (Ca, Cc), et ce à leurs extrémités proches de la poutre de guidage (Cd), et deux autres paliers d'air (L2) horizontaux se situent en dessous de la poutre transversale (Cb) située parallèlement à la poutre de guidage (Cd), et ce respectivement aux deux extrémités de cette poutre transversale (Cb).

12. Dispositif de positionnement selon l'une des revendications 7 à 10, le cadre (R) étant guidé sur la base plane (B) au moyen de cinq paliers d'air (L2) horizontaux, parmi lesquels deux paliers d'air (L2) horizontaux se situent respectivement en dessous des poutres longitudinales (Ca, Cc), et ce à leurs extrémités proches des poutres transversales (Cb, Cd), et un autre palier d'air (L2) horizontal se situe en dessous de la poutre transversale (Cb) située parallèlement à la poutre de guidage (Cd), et ce au centre de cette poutre transversale (Cb).

13. Dispositif de positionnement selon l'une des revendications précédentes, l'élément mobile (S) étant guidé sur la surface de guidage (GS) de la poutre de guidage (Cd) au moyen d'un palier d'air (L1) latéral précontraint.

14. Dispositif de positionnement selon l'une des revendications précédentes, une articulation (VAG) étant disposée entre la surface de guidage (GS) de la poutre de guidage (Cd) et l'élément mobile (S), laquelle articulation présente un axe de rotation virtuel (VA) pour une rotation de l'élément mobile (S) autour de la troisième direction (Z).

15. Dispositif de positionnement selon la revendication 14, l'axe de rotation virtuel (VA) passant par un centre de masse de l'élément mobile (S).

16. Dispositif de positionnement selon la revendication 14 ou 15, la rotation de l'élément mobile (S) autour d'une troisième direction (Z), qui est perpendiculaire à la première et à la deuxième direction (Y, X), pouvant être réglée au moyen des deuxièmes entraînements linéaires (LMX1, LMX2).
